# FASCICULE DE BREVET EUROPEEN

(11) **EP 2 786 412 B1**
(45) Date de publication et mention de la délivrance du brevet: **14.04.2021**
(21) Numéro de dépôt: 12798673.5
(22) Date de dépôt: 29.11.2012
(51) Int. Cl.: H01L 27/146

(54) **BLOC DETECTEUR OPTIQUE**
OPTISCHE DETEKTOREINHEIT
OPTICAL DETECTOR UNIT

(30) Priorité: 29.11.2011 FR 1103630
(43) Date de publication de la demande: 08.10.2014
(73) Titulaire: THALES, 92200 Neuilly-sur-Seine (FR); Commissariat à l'Énergie Atomique et aux Énergies Alternatives, 75015 Paris (FR); Alcatel Lucent, 91620 Nozay (FR)
(72) Inventeur: GIFFARD, Benoit, F-38000 Grenoble (FR); HUGON, Xavier, F-38470 Teche (FR); MOUSSY, Norbert, F-38190 Saint Agnes (FR); REVERCHON, Jean-Luc, F-91767 Palaiseau Cedex (FR); BOIS, Philippe, F-91767 Palaiseau Cedex (FR)
(74) Mandataire: Lavoix
(86) Numéro de dépôt international: PCT/EP2012/073980
(87) Numéro de publication internationale: WO 2013/079603

(56) Documents cités:
- EP-A1- 2 267 776
- US-A1- 2006 043 438
- US-A1- 2009 121 307

## Description

La présente invention concerne un bloc détecteur optique, de type hybride, fonctionnant dans une gamme de longueur d'onde donnée et comprenant, de manière superposé :
- un premier détecteur optique, comprenant des éléments de détection formés dans une structure semi-conductrice, chaque élément de détection étant destiné à transformer un flux de photons incidents en un signal électrique, et
- un premier circuit de lecture, pour récupérer le signal électrique de chaque élément de détection.

La présente invention concerne également un procédé de fabrication d'un bloc détecteur optique du type précité comprenant les étapes suivantes :
- fournir un premier détecteur optique, comprenant des éléments de détection formés dans une structure semi-conductrice, chaque élément de détection étant destiné à transformer un flux de photons incidents en un signal électrique, et
- fournir un premier circuit de lecture, pour récupérer le signal électrique de chaque élément de détection.

De manière générale, l'invention se situe dans le domaine de l'imagerie à base de matrice de photodiode, et plus particulièrement l'imagerie à faible intensité de lumière.

On connaît par exemple de la Figure 1 du document US 2011/0031401 un bloc détecteur optique, fonctionnant en éclairage face avant et dans une gamme de longueur d'ondes infrarouge, comprenant un détecteur infrarouge élémentaire, ou élément de détection, formé dans une structure semi-conductrice en HgCdTe et réalisé sous la forme d'une photodiode à jonction N-P. Le détecteur infrarouge comprend en outre une couche de passivation située de part et d'autre de la structure semi-conductrice. En fonctionnement, le détecteur infra-rouge permet de transformer un flux de photons incidents en un signal électrique.

Suivant une architecture hybride, le bloc détecteur optique comprend également un circuit de lecture, également appelé ROIC, acronyme de Read Out Integrated Circuit, assemblé avec le détecteur infra-rouge au moyen d'une couche d'epoxy. Le circuit de lecture, propre à traiter le signal électrique issu du détecteur infra-rouge, comprend une électrode destinée à recevoir ce signal électrique. Cette électrode est reliée au détecteur infra-rouge au moyen d'un contact électrique formé dans un trou d'interconnexion électrique, appelé également via, traversant à la fois la structure semi-conductrice et les couches de diélectrique de passivation.

Un avantage de ce bloc détecteur optique est que la réalisation du contact électrique dans le trou d'interconnexion électrique au niveau du détecteur infra-rouge, et plus précisément en contact avec une zone dopée N de la photodiode à jonction N-P, permet de minimiser le courant d'obscurité généré dans la photodiode.

Toutefois, ce bloc détecteur optique comporte de nombreux inconvénients.

En premier lieu, le fonctionnement de ce bloc détecteur optique est limité à l'infrarouge. Une technique connue pour étendre le fonctionnement dans le visible de blocs détecteurs infra-rouge est de modifier la structure du détecteur infra-rouge, par exemple en supprimant la couche de passivation située sur la structure semi-conductrice du détecteur infra-rouge. Le problème est que cette technique entraîne des modifications de contraste au niveau de l'image généré en sortie du bloc détecteur optique, ce qui crée des difficultés d'interprétation et d'identification sur cette image.

En second lieu, la résolution d'un bloc détecteur optique du type précité comprenant une pluralité de détecteurs élémentaires, par exemple sous la forme d'une matrice, est limitée. Une technique classique pour augmenter la résolution, c'est-à-dire le nombre de détecteurs élémentaires, sur une surface donnée est de diminuer la largeur des détecteurs élémentaires. Cette diminution entraîne un rapprochement des contacts électriques, des trous d'interconnexion électrique, et des jonctions N-P entre chaque détecteur élémentaire, ce qui est générateur de diaphonie entre détecteurs. Aussi, ce problème limite typiquement la largeur d'un détecteur élémentaire à dix microns.

D'autre part, un autre inconvénient de la présence du trou d'interconnexion électrique débouchant en surface du détecteur élémentaire, est qu'il limite le taux de remplissage du détecteur élémentaire et donc la sensibilité du bloc détecteur optique, ce taux de remplissage étant défini comme le rapport entre la surface du détecteur élémentaire utilisée pour la détection de la lumière et la surface totale du détecteur élémentaire.

Un but de l'invention est donc de proposer un bloc détecteur optique avec une gamme spectrale de fonctionnement étendue, propre à une détection multispectrale, tout en présentant des performances améliorées par rapport à l'état de la technique précitée.

A cet effet, l'invention a pour objet un bloc détecteur optique du type précité, caractérisé en ce que le bloc détecteur optique comprend, en outre, un imageur comportant un deuxième détecteur optique destiné à augmenter la gamme de longueur d'ondes de fonctionnement du bloc détecteur optique et un second circuit de lecture pour récupérer des signaux électriques d'éléments de détection du deuxième détecteur optique, et en ce que le premier et le second circuit de lecture sont intégrés ensemble, de manière à former un circuit de lecture commun.

Le circuit de lecture commun comprend des électrodes reliées un à un aux éléments de détection du premier détecteur optique au moyen d'un premier contact électrique, et chaque premier contact électrique est formé dans un trou d'interconnexion électrique traversant la structure semi-conductrice ;

Chaque élément de détection du premier détecteur optique comprend une photodiode comportant une zone dopée annulaire, s'étendant dans la structure semi-conductrice de manière cylindrique autour du trou d'interconnexion électrique (36) sur une profondeur prédéterminée, la zone dopée étant en contact électrique avec l'électrode correspondante.

Suivant d'autres modes de réalisation, le bloc détecteur optique comprend une ou plusieurs des caractéristiques suivantes, prise(s) isolément ou suivant toutes les combinaisons techniquement possibles :
- la zone dopée forme une partie d'une jonction P-N ;
- le bloc détecteur optique fonctionne en éclairage face arrière, et l'imageur et la couche fenêtre sont transparents à l'infrarouge ;
- la zone dopée est obtenue par diffusion ou implantation;
- la structure semi-conductrice comprend une couche fenêtre d'un premier matériau, une couche d'absorption d'un second matériau, et un substrat d'un troisième matériau, et la structure semi-conductrice est un triplet { premier matériau, second matériau, troisième matériau } du groupe consistant en : « { InP, InGaAs, InP }, { GaSb, InAsSb, GaSb}, et {AlGaSb, InAsSb, GaSb} » ;
- l'imageur est sensible à une gamme de longueur d'ondes comprise entre 0,4 et 1 micron, et le premier détecteur optique est sensible à une gamme de longueur d'ondes comprise entre 1 micron et 1,7 micron ;
- il comprend en outre une couche d'assemblage formée par collage moléculaire et destinée à assembler le premier détecteur optique et l'imageur ; et
- il comprend en outre au moins un patch métallique, disposé en contact de la structure semi-conductrice et propre à un confinement optique du flux lumineux incident dans la structure semi-conductrice.

L'invention a également pour objet un procédé de fabrication d'un bloc détecteur optique du type précité, caractérisé en ce qu'il comprend une étape de fourniture d'un imageur comportant un deuxième détecteur optique destiné à augmenter la gamme de longueur d'ondes de fonctionnement du bloc détecteur optique et un second circuit de lecture pour récupérer des signaux électriques d'éléments de détection du deuxième détecteur optique, et une étape d'intégration du premier et du second circuit de lecture, de manière à former un circuit de lecture commun comprenant des électrodes reliées un à un aux éléments de détection du premier détecteur optique au moyen d'un premier contact électrique, chaque premier contact électrique étant formé dans un trou d'interconnexion électrique traversant la structure semi-conductrice,

L'étape de fourniture du premier détecteur optique comprend la fourniture, pour chaque élément de détection du premier détecteur optique, d'une photodiode comportant une zone dopée annulaire et s'étendant dans la structure semi-conductrice de manière cylindrique autour du trou d'interconnexion électrique sur une profondeur prédéterminée, la zone dopée étant en contact électrique avec l'électrode correspondante.

Ces caractéristiques et avantages de l'invention apparaitront à la lecture de la description qui va suivre, donnée uniquement à titre d'exemple et non limitative, et fait en référence aux dessins annexés, sur lesquels :
- la Figure 1 est une représentation schématique d'une coupe d'un bloc détecteur optique selon l'invention, et
- les Figures 2 à 6 sont des coupes du bloc détecteur optique illustrant le procédé de fabrication conforme à l'invention.

Pour des raisons de clarté, les figures et les parties qui les composent ne sont pas représentées à l'échelle.

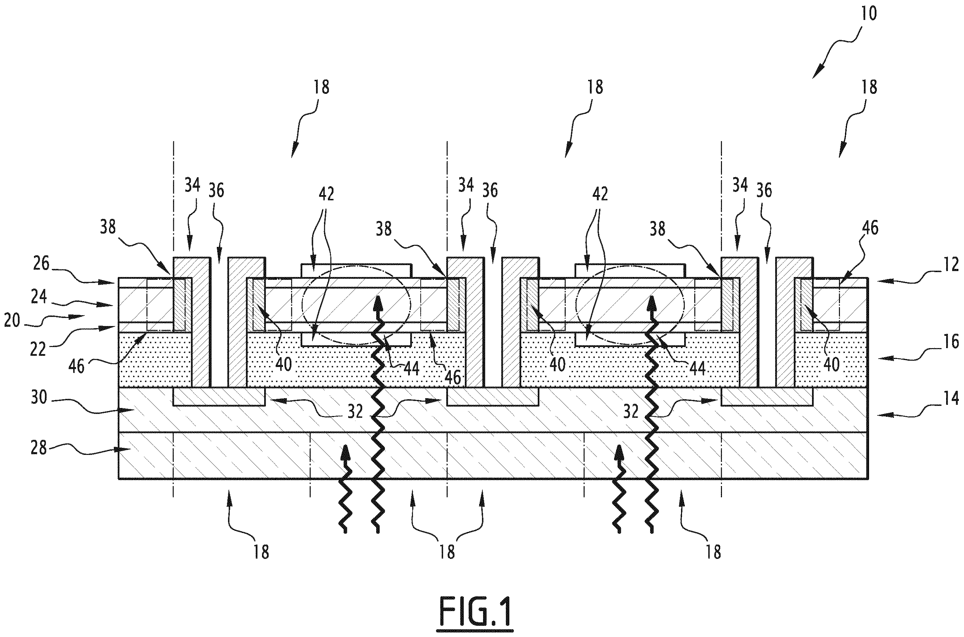

La figure 1 représente un bloc détecteur optique 10 fonctionnant dans une gamme spectrale donnée, par exemple dans une gamme combinant le visible et l'infra-rouge de longueur d'ondes comprise entre 0,4 micron et 1,7 micron.

Le bloc détecteur optique 10 est basé sur une architecture hybride en éclairage face arrière, et comprend un premier détecteur optique 12, comme par exemple un détecteur infrarouge, assemblé à un imageur 14 au moyen d'une couche d'assemblage 16.

Le premier détecteur optique 12 comprend des éléments de détection 18, ou pixels, agencés sous forme de matrice et formés dans une structure semi-conductrice 20 comportant une couche fenêtre 22, une couche d'absorption 24, et un substrat 26. Chaque élément de détection 18, de largeur typique égale à dix microns, est destiné à transformer un flux de photons incidents dans l'infra-rouge en un signal électrique.

De manière générale, la structure semi-conductrice 20 est constituée de préférence à base de matériaux III - V.

La couche fenêtre 22, également appelée couche barrière, est, par exemple, de type de conductivité N et en matériau InP. En variante, le matériau de la couche fenêtre 22 est en GaSb, AIGaSb ou AlAsSb.

La couche d'absorption 24 est, par exemple, de type de conductivité N et en matériau InGaAs. En variante, le matériau de la couche d'absorption 24 est en matériau InAsSb, ou InAs.

Le substrat 26 est par exemple en matériau InP. En variante, le substrat 26 est en matériau GaSb, ou InAs.

Dans le cadre d'une utilisation du bloc détecteur optique 10 en éclairage face arrière, la couche fenêtre 22 est transparente à l'infra-rouge dans la gamme spectrale de fonctionnement.

De manière préférée, la structure semi-conductrice 20 est un assemblage InP, InGaAs, InP. A titre d'exemple, la structure semi-conductrice 20 a une épaisseur de 0,5 microns.

L'imageur 14 comprend, d'une part un deuxième détecteur optique 28, sensible par exemple dans le visible, et d'autre part un circuit de lecture commun 30, typiquement un multiplexeur, associé à la fois au premier détecteur optique 12 et au deuxième détecteur optique 28.

Le circuit de lecture commun 30 intègre fonctionnellement, à la fois, un premier circuit de lecture, classiquement associé au premier détecteur optique 12 et un second circuit de lecture typique d'un imageur CMOS, afin de pouvoir effectuer une lecture des éléments de détection 18 du premier détecteur optique 12 et des éléments de détection 18 du deuxième détecteur optique 28.

L'imageur 14, est, par exemple, un imageur CMOS, de l'anglais Complementary Metal Oxyde Semiconductor, comprenant un ensemble d'éléments de détection 18, ou pixels CMOS, de largeur égale à cinq microns par exemple.

Le circuit de lecture commun 30 comprend des électrodes 32 destinées à récupérer le signal électrique de chaque élément de détection 18 du premier détecteur optique 12, chaque électrode 32 étant reliée directement un à un aux éléments de détection 18 au moyen d'un premier contact électrique 34, ou contact P, formé dans un trou d'interconnexion électrique 36 traversant la structure semi-conductrice 20 et la couche d'assemblage 16. De manière préférée, comme illustré sur la figure 1, le trou d'interconnexion électrique 36 est vertical et a une profondeur typique inférieure à 1,5 micron.

De manière plus précise, chaque élément de détection 18 comprend une photodiode 38 comportant une zone dopée 40, par exemple de type de conductivité P, de manière à former une partie d'une jonction P-N dans la couche d'absorption 24. La zone dopée 40 est annulaire et s'étend dans la structure semi-conductrice 20 de manière cylindrique autour du trou d'interconnexion électrique 36 sur une profondeur prédéterminée, par exemple de 0,1 micron. De préférence, comme illustré sur la figure 1, la zone dopée 40 est formée uniformément autour du trou d'interconnexion électrique 36 de manière à former une partie d'une jonction P-N verticale.

De manière préférée, le bloc détecteur optique 10 comprend en outre au moins un patch métallique 42, permettant un couplage plasmon et un second contact électrique associé de manière à former un seul élément. Le patch métallique 42 est disposé en contact de la structure semi-conductrice 20 et associé à chaque élément de détection 18.

Le patch métallique 42, également appelé réflecteur ou patch électromagnétique, est propre à un confinement optique 44 du flux lumineux incident dans la structure semi-conductrice 20, de manière à améliorer l'absorption des photons incidents infra-rouge dans la couche d'absorption 24. Cette amélioration de l'absorption permet de réduire l'épaisseur de la couche d'absorption 24, ce qui est propre à une minimisation du courant d'obscurité et de la capacité électrique de la photodiode 38.

Le second contact électrique, ou contact N, associé à chaque photodiode 38, permet d'appliquer un potentiel au niveau de la structure semi-conductrice 20 de type de conductivité N de la photodiode 38, de manière à polariser la jonction P-N.

Ainsi, la zone dopée 40 constitue une partie d'une jonction P-N, dont l'autre partie est constituée du second contact électrique de polarité opposée et de la couche d'absorption 24.

En variante, le plasmon et le second contact électrique sont dissociés de manière à former deux éléments distincts.

Dans un autre mode de réalisation (non représenté), des micro-lentilles sont disposées en contact avec chaque élément de détection 18, ou pixel CMOS, de l'imageur 14 de manière à améliorer la détection optique du bloc détecteur optique 10.

Le fonctionnement du bloc détecteur optique 10 visible sur la figure 1 va être à présent décrit.

Dans un mode de réalisation préféré, chaque photodiode 38 du bloc détecteur optique 10 est de type PiN, en mode de fonctionnement photovoltaïque dans lequel une polarisation est appliquée au niveau du premier contact électrique 34, et du patch métallique 42 de manière à générer un champ électrique E permettant de créer une zone de déplétion 46, également appelée zone de désertion. De manière plus précise, la zone de déplétion 46, de largeur typique supérieure à 1,5 micron, est située autour de la jonction P-N cylindrique, tout en étant plutôt localisée en dehors de la zone dopée 40 de type de conductivité P.

En fonctionnement en éclairage face arrière, un flux lumineux incident dans une gamme de longueur d'ondes s'étendant du visible à l'infra-rouge, atteint l'imageur 14, c'est-à-dire l'imageur CMOS, du bloc détecteur optique 10.

Une partie du flux lumineux incident sous la forme de photons de longueur d'ondes visibles et proche infra-rouge, typiquement entre 0,4 micron et 1 micron, est détectée par les éléments de détection 18 du deuxième détecteur optique 28 qui génèrent un courant électrique, ou photocourant pour chaque éléments de détection 18. Ensuite, le circuit de lecture commun 30 reçoit, traite et achemine le courant électrique issu de chaque élément de détection 18 à un dispositif électronique externe afin de créer une première image dans le visible.

Une seconde partie du flux lumineux sous la forme de photons de longueur d'ondes infrarouges, typiquement entre 1 micron et 1,7 microns, traversent l'imageur 14, la couche d'assemblage 16, et la couche fenêtre 22, ces derniers étant transparents à l'infra-rouge de 1 à 1,7 µm.

Ensuite, les photons de longueur d'ondes infrarouges atteignent la couche d'absorption 24 dans laquelle chaque photon crée une paire électron-trou qui diffuse vers la zone de déplétion 46,

Sous l'effet du champ électrique interne E, une dissociation de la paire électron-trou s'effectue et les trous, de charge positive, sont récoltés par le premier contact électrique 34 au travers de la jonction P-N cylindrique via la zone dopée 40. Au niveau de chaque élément de détection 18 du premier détecteur optique 12, l'ensemble des charges récoltées génère ainsi un courant électrique proportionnel à l'éclairage reçu, et plus précisément proportionnel aux nombres de photons infrarouges reçus.

Ensuite, pour chaque élément de détection 18, le circuit de lecture commun 30 reçoit le courant électrique via l'électrode 32, puis traite et achemine ce courant électrique vers le dispositif électronique externe afin de créer une seconde image dans l'infra-rouge.

Ainsi, le bloc détecteur optique 10 selon l'invention permet d'obtenir à la fois une image infra-rouge et une image visible, de manière à permettre une détection multispectrale. L'image visible étant obtenue par un imageur CMOS, celle-ci présente une résolution potentiellement très élevé. En prenant l'exemple d'une image visible obtenue à partir de pixels de cinq microns, et d'une image infra-rouge obtenue à partir de pixels de dix microns, la résolution de l'image visible est alors quatre fois supérieure à l'image infrarouge. Ainsi, la combinaison des deux images permet un traitement d'images amélioré en termes d'interprétation et d'identification, et notamment la mise en évidence d'objets d'intérêt reconnaissables, dans certains cas, uniquement sur un type d'image dans une gamme spectrale spécifique.

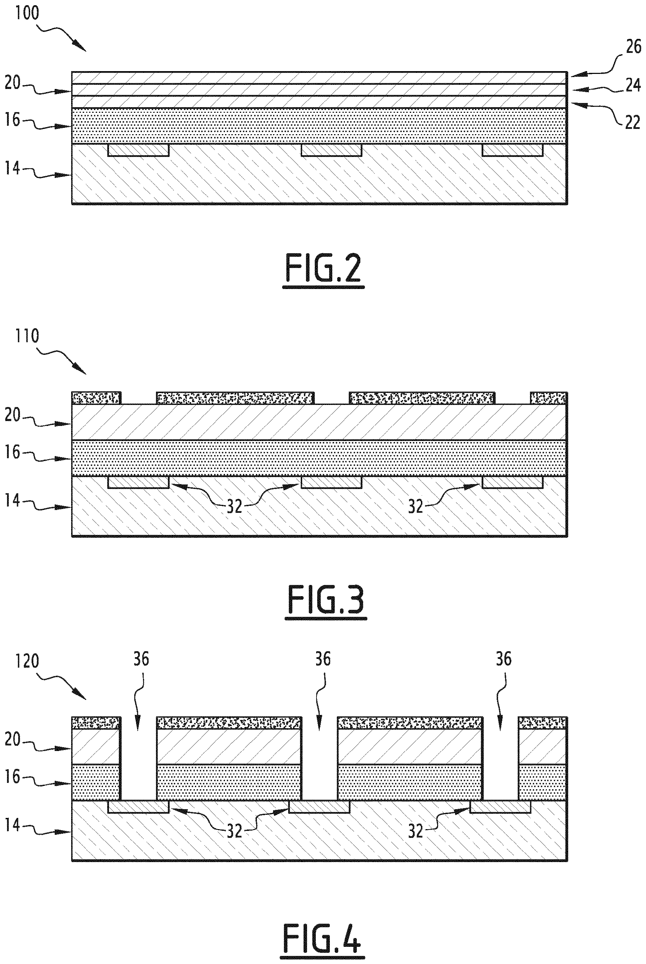

Le procédé de fabrication d'un bloc détecteur optique 10 selon l'invention va être à présent décrit, à l'aide des figures 2 à 6.

Lors d'une étape 100, il est fourni une structure semi-conductrice 20 comprenant un substrat 26 sur lequel on forme par croissance épitaxiale, une couche d'absorption 24, par exemple en InGaAs de type de conductivité N. Ensuite, on forme sur la couche d'absorption 24 également par croissance épitaxiale une couche fenêtre 22, par exemple en InP de type de conductivité N, de manière à obtenir la structure semi-conductrice 20, visible sur la figure 2.

Ensuite, il est fourni un imageur 14, tel qu'un imageur CMOS, puis on procède à un assemblage, également appelé hybridation, de l'imageur 14 avec la couche semi-conductrice 12, au moyen d'une couche d'assemblage 16.

De préférence, l'assemblage est réalisé par « direct bonding », ou « collage direct » en français, et plus spécifiquement par collage moléculaire afin obtenir une couche d'assemblage 16 sous la forme d'un diélectrique de collage moléculaire. Le diélectrique de collage moléculaire est réalisé, en pleine plaque, à des températures dites basses, typiquement entre 200 °C et 400°C, générant une forte énergie de surface par adhésion moléculaire.

Lors d'une étape 110, représentée sur la figure 3, on effectue un dépôt d'une couche diélectrique de masquage sur la structure semi-conductrice 20. Puis, on effectue une attaque chimique d'une partie de la couche diélectrique de masquage en regard des électrodes 32 de l'imageur 14.

Ensuite, lors d'une étape 120 visible sur la figure 4, on réalise une gravure de trous 36, s'étendant de manière sensiblement verticale jusqu'aux électrodes 32, au travers de la structure semi-conductrice 20 et de la couche d'assemblage 16. La gravure est réalisée par voie sèche ou par voie chimique.

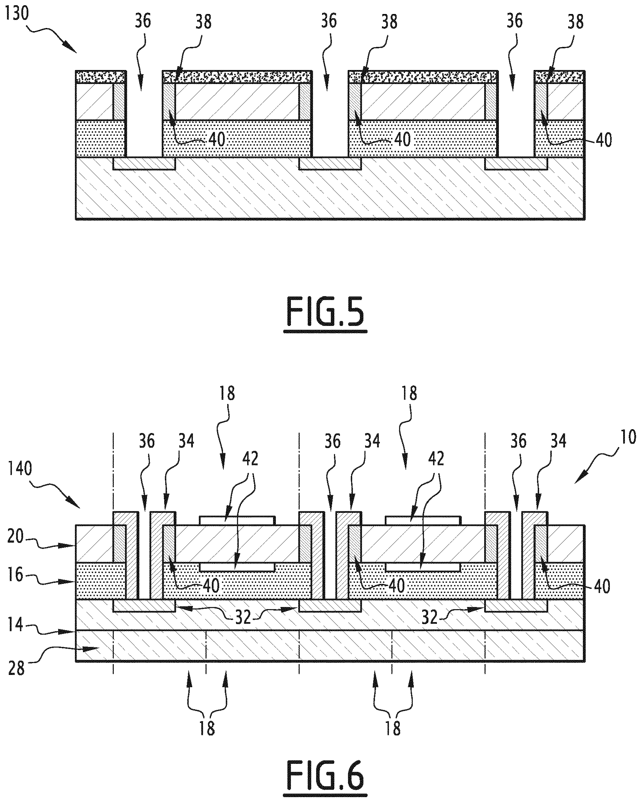

Lors d'une étape 130, illustrée sur la figure 5, on réalise une zone dopée 40, par exemple de type de conductivité P+, par diffusion ou par implantation ionique au travers de chaque trou 36, de manière à former une photodiode 38 comprenant une jonction P-N cylindrique. De préférence, la zone dopée 40 est obtenue par diffusion Zinc.

Puis, lors d'une étape 140, on procède d'une part à une métallisation des premiers contacts électriques 34 dans les trous 36 de manière à mettre en contact électrique la zone dopée 40 et l'électrode 32, et d'autre part à une métallisation de deux patchs métalliques 42, associés à chaque photodiode 38, en contact au dessus et au-dessous de la structure semi-conductrice 20, telle qu'illustrée sur la figure 5.

A l'issue de l'étape 140, on obtient un bloc détecteur optique 10 de type hybride selon l'invention comprenant sur une face supérieure un ensemble d'éléments de détection 18, ou pixels, réalisé de préférence sous la forme d'une matrice, et sur une face inférieure une matrice d'éléments de détection 18, ou pixels CMOS, de l'imageur CMOS.

Ainsi, le bloc détecteur optique selon l'invention permet, grâce à une extension de la gamme spectrale de fonctionnement, une détection multispectrale propre à une amélioration des performances en traitement d'images, notamment en matière de reconnaissance et d'identification.

Le fonctionnement en éclairage face arrière du bloc détecteur optique permet en outre d'obtenir de manière générale une meilleure résolution et un taux de remplissage amélioré.

Enfin, le procédé d'hybridation utilisé combinant l'utilisation de collage moléculaire, de circuit de lecture commun et de patchs plasmon permet l'obtention d'un bloc détecteur optique à moindre coût, et à dimensions compactes tout en présentant des performances optimisées.

## Revendications

1. Bloc détecteur optique, de type hybride, fonctionnant dans une gamme de longueur d'onde donnée et comprenant, de manière superposée :
- un premier détecteur optique (12), comprenant des éléments de détection (18) formés dans une structure semi-conductrice (20), chaque élément de détection (18) étant destiné à transformer un flux de photons incidents en un signal électrique, et
- un premier circuit de lecture, pour récupérer le signal électrique de chaque élément de détection (18),
- un imageur (14) comportant un deuxième détecteur optique (28) destiné à augmenter la gamme de longueur d'ondes de fonctionnement du bloc détecteur optique (10) et un second circuit de lecture pour récupérer des signaux électriques d'éléments de détection (18) du deuxième détecteur optique (28), le premier et le second circuit de lecture étant intégrés ensemble, de manière à former un circuit de lecture commun (30),
- le circuit de lecture commun (30) comprenant des électrodes (32) reliées un à un aux éléments de détection (18) du premier détecteur optique (12) au moyen d'un premier contact électrique (34), chaque premier contact électrique (34) étant formé dans un trou d'interconnexion électrique (36) traversant la structure semi-conductrice (20),
**caractérisé en ce que** chaque élément de détection (18) du premier détecteur optique (12) comprend une photodiode (38) comportant une zone dopée (40) annulaire et s'étendant dans la structure semi-conductrice (20) de manière cylindrique autour du trou d'interconnexion électrique (36) sur une profondeur prédéterminée, la zone dopée (40) étant en contact électrique avec l'électrode (32) correspondante.

2. Bloc détecteur optique selon la revendication 1, **caractérisé en ce que** la zone dopée (40) forme une partie d'une jonction P-N.

3. Bloc détecteur optique selon l'une quelconque des revendications 1 et 2, **caractérisé en ce que** le bloc détecteur optique (10) fonctionne en éclairage face arrière, et **en ce que** l'imageur (14) est transparent à l'infrarouge.

4. Bloc détecteur optique selon l'une quelconque des revendications 1 à 3, **caractérisée en ce que** la structure semi-conductrice (20) comprend une couche fenêtre (22) d'un premier matériau, une couche d'absorption (24) d'un second matériau, et un substrat (26) d'un troisième matériau, et **en ce que** la structure semi-conductrice (20) est un triplet { premier matériau, second matériau, troisième matériau } du groupe consistant en : « { InP, InGaAs, InP }, { GaSb, InAsSb, GaSb}, et { AIGaSb, InAsSb, GaSb} ».

5. Bloc détecteur optique selon la revendication 4, **caractérisé en ce qu'**il fonctionne en éclairage face arrière, et **en ce que** la couche fenêtre (22) est transparente à l'infrarouge.

6. Bloc détecteur optique selon l'une quelconque des revendications 1 à 5, **caractérisé en ce que** l'imageur (14) est sensible à une gamme de longueur d'ondes comprise entre 0,4 et 1 micron, et **en ce que** le premier détecteur optique (12) est sensible à une gamme de longueur d'ondes comprise entre 1 micron et 1,7 micron.

7. Bloc détecteur optique selon l'une quelconque des revendications 1 à 6, **caractérisé en ce qu'**il comprend en outre au moins un patch métallique (42), disposé en contact de la structure semi-conductrice (20) et propre à un confinement optique (44) du flux lumineux incident dans la structure semi-conductrice (20).

8. Procédé de réalisation d'un bloc détecteur optique (10) selon l'une quelconque des revendications précédentes, comprenant les étapes suivantes :
- fourniture d'un premier détecteur optique (12), comprenant des éléments de détection (18) formés dans une structure semi-conductrice (20), chaque élément de détection (18) étant destiné à transformer un flux de photons incidents en un signal électrique, et
- fourniture d'un premier circuit de lecture, pour récupérer le signal électrique de chaque élément de détection (18),
- fourniture d'un imageur (14) comportant un deuxième détecteur optique (28) destiné à augmenter la gamme de longueur d'ondes de fonctionnement du bloc détecteur optique (10) et un second circuit de lecture pour récupérer des signaux électriques d'éléments de détection (18) du deuxième détecteur optique (28),
- intégration du premier et du second circuit de lecture, de manière à former un circuit de lecture commun (30) comprenant des électrodes (32) reliées un à un aux éléments de détection (18) du premier détecteur optique (12) au moyen d'un premier contact électrique (34), chaque premier contact électrique (34) étant formé dans un trou d'interconnexion électrique (36) traversant la structure semi-conductrice (20),
**caractérisé en ce que** l'étape de fourniture du premier détecteur optique (12) comprend la fourniture, pour chaque élément de détection (18) du premier détecteur optique (12), d'une photodiode (38) comportant une zone dopée (40) annulaire et s'étendant dans la structure semi-conductrice (20) de manière cylindrique autour du trou d'interconnexion électrique (36) sur une profondeur prédéterminée, la zone dopée (40) étant en contact électrique avec l'électrode (32) correspondante.

## Patentansprüche

1. Optischer Detektorblock des Hybridtyps, der in einem gegebenen Wellenlängenbereich funktioniert und auf übereinander angeordnete Weise aufweist:
- einen ersten optischen Detektor (12), der Detektionselemente (18) aufweist, die in einer Halbleiterstruktur (20) ausgebildet sind, wobei jedes Detektionselement (18) vorgesehen ist, um einen Fluss von einfallenden Photonen in ein elektrisches Signal umzuwandeln, und
- eine erste Leseschaltung, um das elektrische Signal von jedem Detektionselement (18) wiederzuerlangen,
- einen Bildgeber (14), aufweisend einen zweiten optischen Detektor (28), der vorgesehen ist, um den Funktionswellenlängenbereich des optischen Detektorblocks (10) zu erhöhen, und eine zweite Leseschaltung, um elektrische Signale von Detektionselementen (18) des zweiten optischen Detektors (28) wiederzuerlangen, wobei die erste und die zweite Leseschaltung zusammen integriert sind, um eine gemeinsame Leseschaltung (30) zu bilden,
- die gemeinsame Leseschaltung (30), die Elektroden (32) aufweist, die einzeln mit den Detektionselementen (18) des ersten optischen Detektors (12) mittels eines ersten elektrischen Kontakts (34) verbunden sind, wobei jeder erste elektrische Kontakt (34) in einem Elektrische-Verbindung-Loch (36) ausgebildet ist, das durch die Halbleiterstruktur (20) hindurchgeht,
**dadurch gekennzeichnet, dass** jedes Detektionselement (18) des ersten optischen Detektors (12) eine Fotodiode (38) aufweist, die einen ringförmigen dotierten Bereich (40) aufweist und sich in der Halbleiterstruktur (20) auf zylindrische Weise um das Elektrische-Verbindung-Loch (36) herum in einer vorbestimmten Tiefe erstreckt, wobei der dotierte Bereich (40) in elektrischem Kontakt mit der korrespondierenden Elektrode (32) ist.

2. Optischer Detektorblock gemäß Anspruch 1, **dadurch gekennzeichnet, dass** der dotierte Bereich (40) einen Teil eines P-N-Übergangs bildet.

3. Optischer Detektorblock gemäß irgendeinem der Ansprüche 1 und 2, **dadurch gekennzeichnet, dass** der optische Detektorblock (10) mit Rückseite-Beleuchtung funktioniert, und dass der Bildgeber (14) für Infrarot transparent ist.

4. Optischer Detektorblock gemäß irgendeinem der Ansprüche 1 bis 3, **dadurch gekennzeichnet, dass** die Halbleiterstruktur (20) eine Fensterschicht (22) aus einem ersten Material, eine Absorptionsschicht (24) aus einem zweiten Material und ein Substrat (26) aus einem dritten Material aufweist, und dass die Halbleiterstruktur (20) ein Triplett {erstes Material, zweites Material, drittes Material} der Gruppe bestehend aus "{InP, InGaAs, InP}, {GaSb, InAsSb, GaSb} und {AlGaSb, InAsSb, GaSb}" ist.

5. Optischer Sensorblock gemäß Anspruch 4, **dadurch gekennzeichnet, dass** er mit Rückseite-Beleuchtung funktioniert, und dass die Fensterschicht (22) für Infrarot transparent ist.

6. Optischer Detektorblock gemäß irgendeinem der Ansprüche 1 bis 5, **dadurch gekennzeichnet, dass** der Bildgeber (14) für einen Wellenlängenbereich zwischen 0,4 und 1 Mikron empfindlich ist, und dass der erste optische Detektor (12) für einen Wellenlängenbereich zwischen 1 Mikron und 1,7 Mikron empfindlich ist.

7. Optischer Detektorblock gemäß irgendeinem der Ansprüche 1 bis 6, **dadurch gekennzeichnet, dass** er ferner mindestens einen Metallflicken (42) aufweist, der in Kontakt mit der Halbleiterstruktur (20) angeordnet und für eine optische Begrenzung (44) des einfallenden Lichtstroms in der Halbleiterstruktur (20) geeignet ist.

8. Verfahren zur Herstellung eines optischen Detektorblocks (10) gemäß irgendeinem der vorhergehenden Ansprüche, aufweisend die folgenden Schritte:
- Bereitstellen eines ersten optischen Detektors (12), der Detektionselemente (18) aufweist, die in einer Halbleiterstruktur (20) ausgebildet sind, wobei jedes Detektionselement (18) vorgesehen ist, um einen Fluss von einfallenden Photonen in ein elektrisches Signal umzuwandeln, und
- Bereitstellen einer ersten Leseschaltung, um das elektrische Signal von jedem Detektionselement (18) wiederzuerlangen,
- Bereitstellen eines Bildgebers (14), aufweisend einen zweiten optischen Detektor (28), der vorgesehen ist, um den Funktionswellenlängenbereich des optischen Detektorblocks (10) zu erhöhen, und eine zweite Leseschaltung, um elektrische Signale von Detektionselementen (18) des zweiten optischen Detektors (28) wiederzuerlangen,
- Integrieren der ersten und der zweiten Leseschaltung, um eine gemeinsame Leseschaltung (30) zu bilden, die Elektroden (32) aufweist, die einzeln mit den Detektionselementen (18) des ersten optischen Detektors (12) mittels eines ersten elektrischen Kontakts (34) verbunden sind, wobei jeder erste elektrische Kontakt (34) in einem Elektrische-Verbindung-Loch (36) ausgebildet ist, das durch die Halbleiterstruktur (20) hindurchgeht,
**dadurch gekennzeichnet, dass** der Schritt des Bereitstellens des ersten optischen Detektors (12) das Bereitstellen, für jedes Detektionselement (18) des ersten optischen Detektors (12), einer Fotodiode (38) aufweist, die einen ringförmigen dotierten Bereich (40) aufweist und sich in der Halbleiterstruktur (20) auf zylindrische Weise um das Elektrische-Verbindung-Loch (36) in einer vorbestimmten Tiefe erstreckt, wobei der dotierte Bereich (40) in elektrischem Kontakt mit der korrespondierenden Elektrode (32) ist.

## Claims

1. An optical detector unit, of the hybrid type, operating in a given wavelength range and comprising, in superposed manner:
- a first optical detector (12), comprising detecting elements (18) formed in a semiconductor structure (20), each detecting element (18) being intended to convert a flux of incident photons into an electrical signal, and
- a first read out circuit, for reading the electrical signal from each detecting element (18),
- an imaging system (14) including a second optical detector (28) intended for increasing the range of operating wavelengths of the optical detector unit (10) and a second read out circuit for reading the electrical signals from the detecting elements (18) of the second optical detector (28), the first read out circuit and the second read out circuit being integrated together, in a manner so as to form a common read out circuit (30),
- the common read out circuit (30) comprising of electrodes (32) connected one by one to the detecting elements (18) of the first optical detector (12) by means of a first electrical contact (34), each first electrical contact (34) being formed in an electrical interconnection hole (36) that passes through the semiconductor structure (20),
**characterised in that** each detecting element (18) of the first optical detector (12) comprises a photodiode (38) including a doped zone (40) that is annular and extending in the semiconductor structure 20 in a cylindrical manner around the electrical interconnection hole (36) up to a predetermined depth, the doped zone (40) being in electrical contact with the corresponding electrode (32).

2. An optical detector unit according to claim 1, **characterised in that** the doped zone (40) forms one portion of a P-N junction.

3. An optical detector unit according to any one of claims 1 and 2, **characterised in that** the optical detector unit (10) operates on back side illumination, and **in that** the imaging system (14) is transparent to/at the Infrared spectrum.

4. An optical detector unit according to any one of claims 1 to 3, **characterised in that** the semiconductor structure (20) comprises of a window layer (22) made of a first material, an absorption layer (24) made of a second material, and a substrate (26) made of a third material, and **in that** the semiconductor structure (20) is a triplet { first material, second material, third material} of the group consisting of : " { InP, InGaAs, InP }, { GaSb, InAsSb, GaSb}, and { AlGaSb, InAsSb, GaSb} ".

5. An optical detector unit according to claim 4, **characterised in that** it operates on back side illumination, and **in that** the window layer (22) is transparent to the Infrared spectrum.

6. An optical detector unit according to any one of claims 1 to 5, **characterised in that** the imaging system (14) is sensitive to a wavelength range of between 0.4 micron and 1 micron, and **in that** the first optical detector (12) is sensitive to a wavelength range of between 1 micron and 1.7 micron.

7. An optical detector unit according to any one of claims 1 to 6, **characterised in that** it further comprises at least a metal patch (42), disposed in contact with the semiconductor structure (20) and suitable for the optical confinement (44) of the incident luminous flux in the semiconductor structure (20).

8. A method of producing an optical detector unit (10) according to any one of the preceding claims, comprising of the following steps :
- provision of a first optical detector (12), comprising detecting elements (18) formed in a semiconductor structure (20), each detecting element (18) being intended for converting a flux of incident photons into an electrical signal ; and
- provision of a first read out circuit, for reading the electrical signal from each detecting element (18),
- provision of an imaging system (14) having a second optical detector (28) intended for increasing the range of operating wavelengths of the optical detector unit (10) and a second read out circuit for reading the electrical signals from the detecting elements (18) of the second optical detector (28),
- integration of the first read out circuit and the second read out circuit, in a manner so as to form a common read out circuit (30) comprising of electrodes (32) connected one by one to the detecting elements (18) of the first optical detector (12) by means of a first electrical contact (34), each first electrical contact (34) being formed in an electrical interconnection hole (36) passing through the semiconductor structure (20),
**characterised in that** the step of providing the first optical detector (12) comprises the provision, for each detecting element (18) of the first optical detector (12), a photodiode (38) including a doped zone (40) that is annular and extending into the semiconductor structure (20) in a cylindrical manner around the electrical interconnection hole (36) up to a predetermined depth, the doped zone (40) being in electrical contact with the corresponding electrode (32).
